# EUROPEAN PATENT SPECIFICATION

(11) **EP 0 418 000 B1**
(45) Date of publication and mention of the grant of the patent: **11.01.1995**
(21) Application number: 90309839.0
(22) Date of filing: 07.09.1990
(51) Int. Cl.: H05K 7/14

(54) **Electronic equipment assembly**
Elektronische Ausrüstungsanordnung
Assemblage d'équipement électronique

(30) Priority: 11.09.1989 US 405611
(43) Date of publication of application: 20.03.1991
(73) Proprietor: International Business Machines Corporation, Armonk, N.Y. 10504 (US)
(72) Inventor: Bristoll, Truman Kenly, Red Hook, New York 12571 (US)
(74) Representative: Moss, Robert Douglas

(56) References cited:
- EP-A- 0 416 771
- US-A- 3 198 991
- US-A- 3 443 161
- US-A- 3 833 840

## Description

### Technical Field of the Invention

This invention relates to an electronic equipment assembly comprising stacks of multiple circuit boards mounted in frames and more particularly to an assembly which permits shorter length cables interconnecting boards within a frame and also boards in one frame to boards in other frames.

### Background of the Invention

The processing speed and the size of computer assemblies is growing at a rapid rate. There are foreseen further increases in the number of parallel processing elements and ever larger computer assemblies requiring faster and faster speeds. This is particularly true in supercomputer designs. The circuits are often placed on a circuit board or card and several of these cards are mounted onto frames. There are interconnections between cards on a frame and there is frequently a need to make interconnection by cables between the cards or boards on one frame to cards or boards on other frames. With such high speed circuitry, signal propagation delay between boards can be significant and it is thus highly desirable to find a manner in which the circuit boards can be closely packed and interconnection lengths minimized. It is further desirable that these lengths be equalized to prevent skewing errors.

In a typical prior art circuit assembly, circuit modules such as IBM (International Business Machines Corporation) TCMs (Temperature Control Modules) are solder connected to rectangular printed circuit cards. The input/output connections to the circuitry of each card are brought out to printed circuit lines at the edge of the card. A large number of the cards are inserted into electrical connectors on a large printed circuit board sometimes referred to as a "motherboard". In a typical prior art circuit assembly the circuit elements are mounted on the printed cards which are themselves mounted on a larger printed circuit board which provides electrical interconnection between the circuit cards.

Conventional packaging technigues place the component mounting boards parallel to the long axis of the frame. The boards packaged within the frame using this concept are separated by one another by the width of the frame and therefore the communication distance between these boards is increased by the width of the centre frame.

### Disclosure of the Invention

The invention provides an electronic equipment assembly comprising a plurality of interconnected stacks of circuit boards, the arrangement of the stacks defining a centre of the assembly with the boards within each stack extending in a parallel step like fashion away from the centre of the assembly, the boards of one stack being parallel to or coplanar with the boards of the other stacks and having connectors at an end nearest the centre; the assembly further comprising cables interconnecting the boards via the connectors.

In this way the boards have their connectors at the end closest to the other boards and facing generally toward the centre of the assembly. The cables interconnect the boards at these connectors. This configuration thus permits shorter length cables interconnecting boards.

The claimed arrangement of stacks of circuit boards giving shorter distances between boards may find beneficial use in a number of systems employing high speed circuitry. However it is preferred that the electronic equipment assembly is a computer assembly.

Preferred embodiments of the invention will now be described, by way of example only, with reference to the accompanying drawings:

### Brief Description of the Drawings

Fig. 1 is a top plan view of a computer assembly according to the prior art packaging techniques;
Fig. 2 is a top plan view of an electronic equipment assembly according to a first embodiment of the present invention;
Fig. 3 is a top plan view of an assembly with the top of the frame removed according to a second embodiment of the present invention;
Fig. 4 is an elevation view of Fig. 3 taken along lines 4-4 in Fig. 3;
Fig. 5 is a top plan view of the assembly of Fig. 2 with cable organizer frames.

### Detailed Description of the Invention

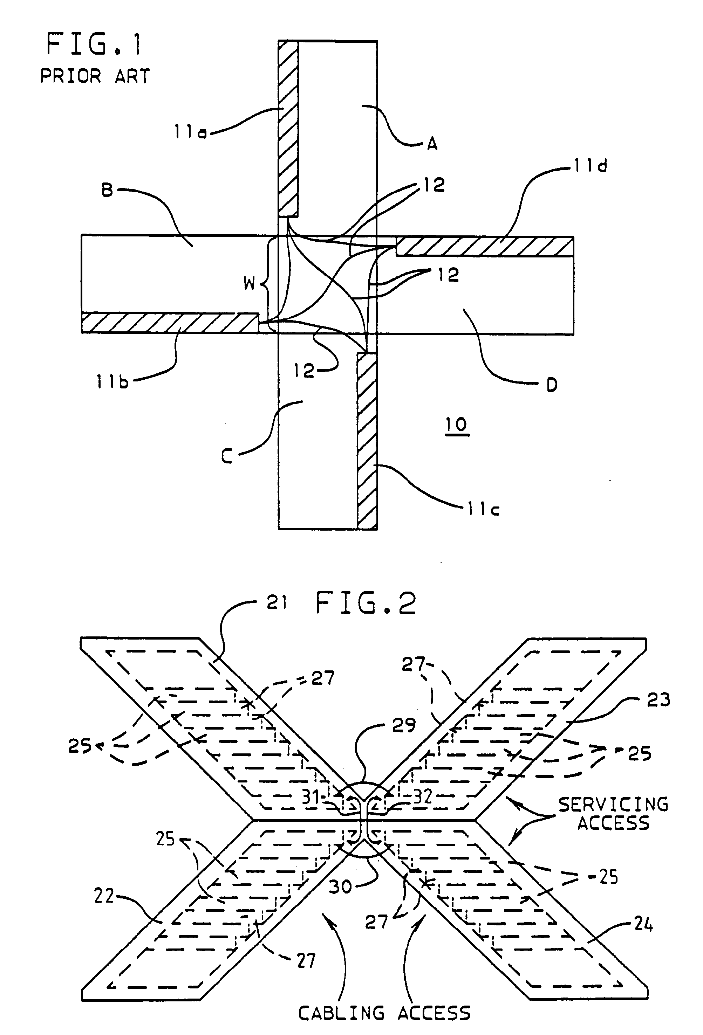

Referring to Fig. 1 there is illustrated a prior art assembly 10 according to a conventional packaging technique for mounting boards and interconnecting frames. As shown, the boards 11a - 11d are packaged within the frames A, B, C and D with the long axis of the boards parallel to the long axis of the corresponding frame. The frames A, B, C, and D are joined to form a cross with a centre section 14 of width W for interconnecting the component boards 11. The connectors of the boards 11a - 11d are at the end nearest to the centre of the frame assembly. Cables 12 provide interconnection between pair of frames such as frame A to frame C or frame B to frame D. As these cables must transverse the width of the centre section, the communication length or delay between these boards is increased by at least the width W of the centre section which is equal to the width of the frame at a minimum.

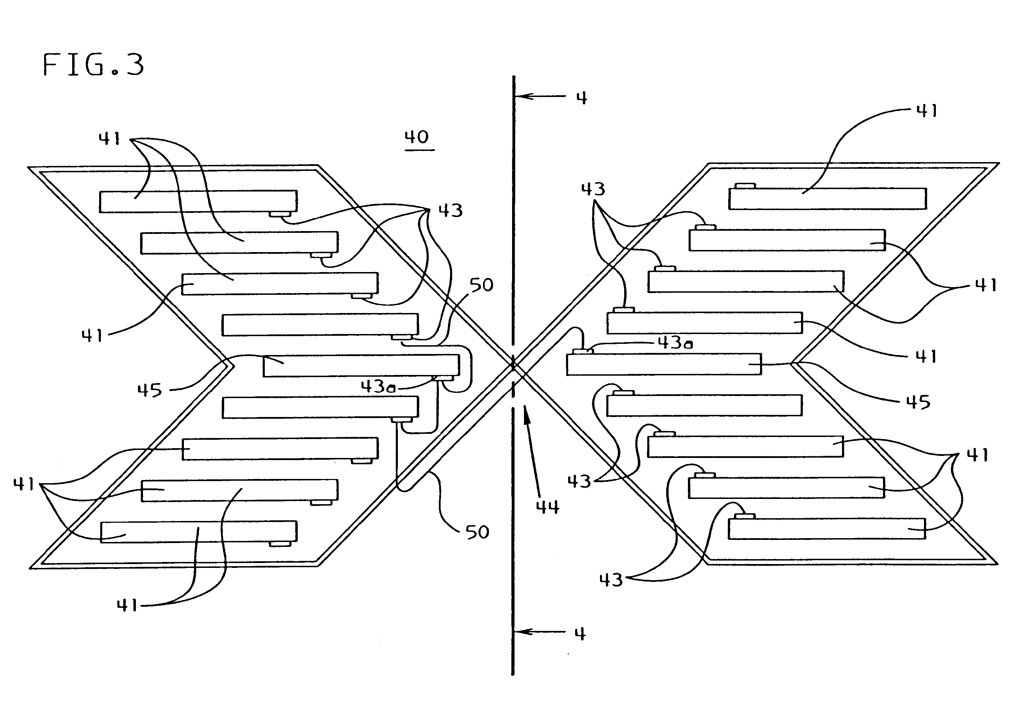

Referring to Fig. 2 there is illustrated a top plan view of a an electronic equipment assembly 20 according to one embodiment of the present invention. Referring to Fig. 2 the four frames 21, 22, 23 and 24 are each oblique parallelogram shaped and each of the frames includes a plurality of parallel staggered offset circuit boards or cards 25. The boards or cards 25 may each hold several IBM TCMs (temperature control modules) with its own power supply. The boards or cards 25 extend in step-like fashion away from the centre of the assembly where the corners of the frames 21-24 are joined. The frames 21-24 and the support boards 25 extend in diagonal directions from the centre. The cabling connectors 27 are located at the end of the boards nearest the centre of the assembly 20. The connectors 27 extend facing one another from frame 21 to frame 23 or from frame 22 to frame 24. The cables between frames 21 and 23 such as cable 29 extend across the V-shaped cable access gap between these frames. Likewise the cabling between frames 22 and 24 is across the gap between these frames as shown by cable 30. The cabling between boards 25 on frames 21 and 22 and 23 and 24 is in the centre region represented by arrows 31 and 32. The boards having the critical connection paths are located closest to the centre of the assembly 20 where the frames are joined so that they may be interconnected via the shortest length cables. The board end opposite the connector end can be open or allow opening for servicing access. Access to the cabling is gained via the inboard end or the end closest to the centre.

Fig. 3 shows a second embodiment of the present invention. The boards 41 are shown with the top cover of the computer free system 40 removed. The boards 41 are parallel to each other and have their connectors 43 at the end 41a nearest the centre 44 of the system 40. The aligned boards 45 are closest to the centre and the other boards 41 in each frame are progressively staggered in parallel relation so the boards 41 form a step-like pattern away from the centre 44 with the connectors 43a of the closer in-board board (closer to the centre) not overlapped by the adjacent board. This permits a shorter length line from board to board in the same frame and closer placement of the boards. The critical boards have to be interconnected with other boards in other frames are located near the centre of the assembly. The close spacing between permits critical boards permits shorter length cables as represented by cables 50.

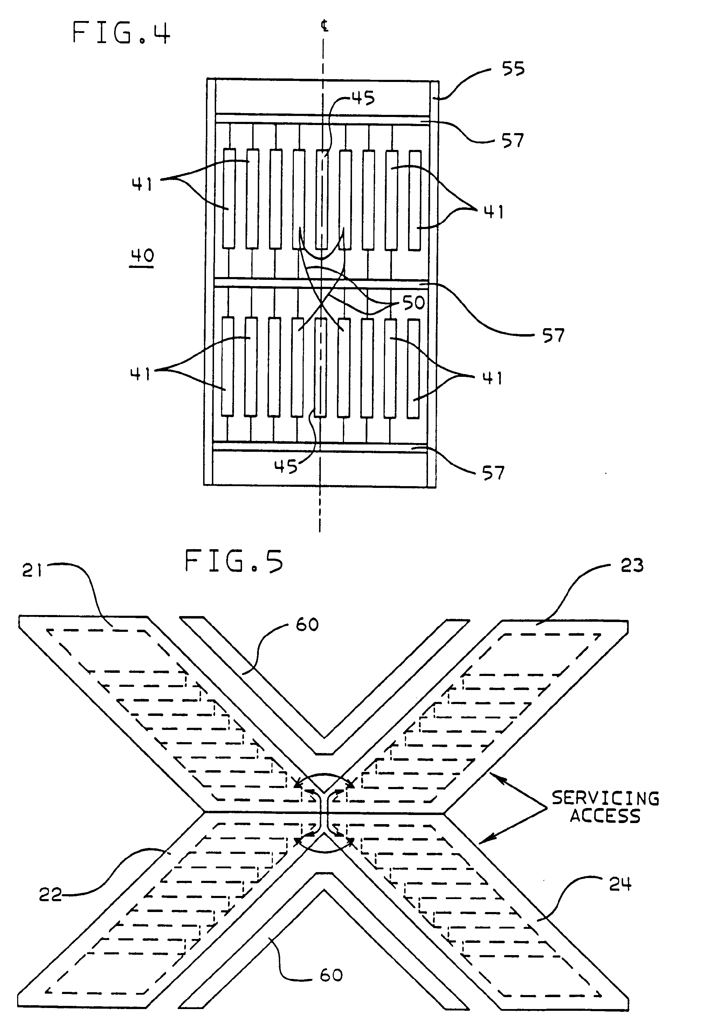

Referring to Fig. 4 there is an elevation view of the boards of Fig. 3 as seen in the 4-4 direction. The boards 41 are slidably mounted to shelves 57 of a bookcase like frame 55 with cables 50 interconnecting the boards. There may be a plurality of shelves. The connectors could be flush with the end surface for easy connection. The boards may, for example, be support boards with PCs boards, TCMs with its own supplies thereon connected by bus lines and panels of connectors mounted across the end of the board and coupled to the board present connectors facing each other and the centre of the assembly. An example of this type of assembly is disclosed in co-pending US application Serial No 404,807, of Casa et al. entitled "High Density Circuit Assembly". In this case the boards and the frames would be in the configuration shown that extend out in step-like fashion from the centre. Further the cabling can be accomplished by two cable frames 60 and 60a as disclosed in co-pending US application Serial No 405,674, of Casa et al. entitled "Cable Organizer". In this case the cable organizer would be in the two V-shaped frames to interconnect frames 21 and 23 and frames 22 and 24 in Fig. 2 as illustrated in Fig. 5.

## Claims

1. An electronic equipment assembly comprising:
a plurality of interconnected stacks of circuit boards, the arrangement of the stacks defining a centre of the assembly, with the boards within each stack extending in a parallel step-like fashion away from the centre of the assembly, the boards of one stack being parallel to or coplanar with the boards of the other stacks and having connectors at an end nearest the centre;
the assembly further comprising cables interconnecting the boards via the connectors.

2. An assembly as claimed in claim 1 wherein the boards located nearest the centre of the assembly are critical path boards through which the boards of one stack are interconnected with boards of a second stack.

3. An assembly as claimed in claim 1 or claim 2 wherein each stack of boards is mounted within a frame, the frames being joined to each other at respective corners.

4. An assembly as claimed in claim 3 wherein there are four stacks of boards mounted in four frames arranged in an X configuration.

## Patentansprüche

1. Eine elektronische Ausrüstungsanordnung mit:
zahlreichen verbundenen Gruppen von Platinen, wobei die Gruppen eine Mitte der Anordnung bilden, und die Platinen in jeder Gruppe parallel in stufenartigem Muster von der Mitte der Anordnung aus weg gehen, und die Platinen einer Gruppe parallel oder koplanar zu den Platinen der anderen Gruppe liegen und Steckverbindungen an dem Ende, das der Mitte am nächsten liegt, haben;
wobei die Anordnung weiterhin Kabel umfaßt, die die Platinen über Steckverbindungen miteinander verbinden.

2. Eine Anordnung nach Anspruch 1, bei der die der Mitte der Anordnung am nächsten liegenden Platinen kritische Pfadplatinen sind, über die die Platinen einer Gruppe mit den Platinen einer zweiten Gruppe verbunden sind.

3. Eine Anordnung nach Anspruch 1 oder Anspruch 2, bei der jede Platinengruppe in einem Rahmen montiert ist, und die Rahmen an den entsprechenden Ecken miteinander verbunden sind.

4. Eine Anordnung nach Anspruch 3, bei der vier Platinengruppen in vier Rahmen in einer X-Konfiguration montiert sind.

## Revendications

1. Assemblage d'équipement électronique comprenant :
une pluralité de piles interconnectées de circuits imprimés, l'agencement des piles définissant un centre de l'assemblage, les circuits imprimés dans chaque pile s'étendant en parallèle et en escalier à partir du centre de l'assemblage, les circuits imprimés d'une première pile étant parallèles ou co-planaires avec les circuits imprimés des autres piles et ayant des connecteurs à une extrémité la plus proche du centre ;
l'assemblage comprenant en outre des câbles interconnectant les circuits imprimés par l'intermédiaire des connecteurs.

2. Assemblage selon la revendication 1, dans lequel les circuits imprimés disposés le plus près du centre de l'assemblage sont des circuits imprimés de chemin critique à travers lesquels les circuits imprimés d'une première pile sont interconnectés avec les circuits imprimés d'une seconde pile.

3. Assemblage selon la revendication 1 ou la revendication 2, dans lequel chaque pile de circuits imprimés est montée dans un boîtier, les boîtiers étant joints l'un à l'autre à des coins respectifs.

4. Assemblage selon la revendication 3, dans lequel quatre piles de circuits imprimés sont montées dans quatre boîtiers agencés selon une configuration en X.
